# EUROPEAN PATENT SPECIFICATION

(11) **EP 0 786 542 B1**
(45) Date of publication and mention of the grant of the patent: **02.10.2002**
(21) Application number: 97300479.9
(22) Date of filing: 27.01.1997
(51) Int. Cl.: C30B 15/00

(54) **Cesium-lithium borate crystal**
Cäsium-Lithiumboratkristall
Cristal de borate de lithium et césium

(30) Priority: 26.01.1996 JP 1235296; 26.01.1996 JP 1235396
(43) Date of publication of application: 30.07.1997
(73) Proprietor: Japan Science and Technology Corporation, Kawaguchi-shi, Saitama 332-0012 (JP)
(72) Inventor: Sasaki, Takatomo, Suita-shi, Osaka (JP); Mori, Yusuke, Katano-shi, Osaka 576 (JP)
(74) Representative: Calamita, Roberto

(56) References cited:
- EP-A- 0 693 581
- CHEMICAL ABSTRACTS, vol. 125, no. 14, 30 September 1996 Columbus, Ohio, US; abstract no. 181704, MORI, YUSUKE: XP002028076 & PROC. SPIE-INT. SOC. OPT. ENG. , no. 2700, 1996, pages 20-27,

## Description

The present invention relates to a cesium-lithium borate crystal. More particularly, the present invention relates to a cesium-lithium borate crystal which is useful as a wavelength converting nonlinear optical crystal or the like for a laser oscillator or an optical parametric oscillator used in ultraviolet-ray lithography, laser fine processing and laser fusion and permits improvement of uniformity of refractive index, improvement of mechanical, chemical and optical properties, and prevention of occurrence of cracks.

In a conventional laser oscillator used in ultraviolet-ray lithography, laser fine processing or laser fusion, it is necessary to obtain stable ultraviolet rays efficiently, and a method of efficiently obtaining ultraviolet rays through wavelength conversion of a light source using a nonlinear optical crystal is attracting general attention as a method for this purpose.

In a pulse YAG laser oscillator as a laser oscillator, the wavelength of a light source is converted with the use of a nonlinear optical crystal to generate triploid harmonic (wavelength: 355 nm) or tetraploid harmonic (wavelength: 266 nm).

Many contrivances have been made regarding a wavelength converting nonlinear optical crystal indispensable for generating ultraviolet rays. For example, crystals of such borates as betabarium metaborate (β-BaB₂O₄), lithium triborate (LiB₃O₅) and cesium triborate (CsB₃O₅) are known. Such a wavelength converting nonlinear optical crystal for generating ultraviolet rays permits transmission of light having a wavelength of up to 200 nm, and has a high nonlinear optical constant.

However, in β-BaB₂O₄, one of such wavelength converting nonlinear optical crystals, the ready occurrence of phase transition upon melt growth during the process of preparation makes it difficult for crystal growth to take place, and a narrow angular allowance leads to a low generality.

In LiB₃O₅ or CsB₃O₅, another of the wavelength converting nonlinear optical crystals, the growing period is very long for flux growth during the process of manufacturing, and phase alignment is possible only for light of a wavelength of up to about 555 nm. It is therefore applicable for the generation of triploid harmonic (wavelength: 355 nm) available by an Nd-YAG laser, for example, but is defective in that it is not applicable for the generation of tetraploid harmonic (wavelength: 266 nm).

Under these circumstances, the present inventors developed a novel cesium-lithium borate crystal, a high-performance wavelength converting nonlinear optical crystal, as a material capable of overcoming the defects in the conventional art, which permitted conversion of light of a shorter wavelength through transmission, gave a high conversion efficiency, and had wide temperature allowance and angular allowance, and have proposed anew this crystal itself, a method of manufacturing the same and a method of utilizing the same (see EP-A-693581 and JP-A-7-128698). This cesium-lithium borate crystal including composition-substituted crystals was clarified to be an epoch-making one, and is attracting general attention as an optical material bringing about new developments.

As a result of studies carried out by the present inventors, in spite of its excellent properties, the above cesium-lithium borate crystal is now known to have problems in that it tends to deteriorate because of its hygroscopicity and water solubility, and residual processing distortion tends to cause cracks.

The present invention aims to solve these problems and has an object to permit improvement of the mechanical, chemical and optical properties of a cesium-lithium borate crystal, a high-performance wavelength converting nonlinear optical crystal, and composition-substituted crystals thereof, which can transmit light of a shorter wavelength and convert the wavelength, have a high conversion efficiency and wide temperature allowance and angular allowance.

In one aspect, the present invention provides a cesium-lithium borate crystal having a chemical composition expressed by the formula:

Cs₁₋ₓLi_{1-y}M_{x+y}B₆O₁₀

(wherein M represents at least one alkali metal element other than Cs and Li, and 0 ≤ x+y < 2, 0 ≤ x < 1 and 0 ≤ y < 1), and wherein the crystal contains a doping element, said doping element being a metal other than an alkali metal or an alkaline earth metal, a semi-metal or a non-metallic element and being present in an amount of 0.1 to 10 mol % relative to the crystal composition.

In another aspect, the present invention provides a cesium-lithium borate crystal having a chemical composition expressed by the formula:

Cs_{2(1-z)}Li₂L_{z}B₁₂O₂₀

(wherein L represents at least one alkaline earth metal element and 0 < z < 1), and wherein the crystal contains a doping element, said doping element being a metal other than an alkali metal or an alkaline earth metal, a semi-metal or a non-metallic element and being present in an amount of 0.1 to 10 mol % relative to the crystal composition.

The doping element is preferably at least one selected from the group consisting of Al, Ge, Ti, C, Si, Ga, Sn, Cu, Cd, Sb, Bi, V, Ta, Mo, W, Sb and P.

In another aspect, the present invention provides a process for the preparation of such a crystal which includes the step of doping with an element as defined above. The crystal may be additionally annealed at a temperature of above 100°C. Such annealing is preferably carried out at a temperature of from 250 to 350°C for 30 minutes to 5 hours. The annealing may be carried out by keeping the crystal at a temperature of from 100°C to 130°C.

In a further aspect of the present invention there is provided a process for the preparation of cesium-lithium borate crystal having a chemical composition expressed by the formula:

Cs₁₋ₓLi_{1-y}M_{x+y}B₆O₁₀

(wherein M represents at least one alkali metal element other than Cs and Li, and 0 ≤ x+y < 2, 0 ≤ x < 1 and 0 ≤ y < 1), wherein the crystal is annealed at a temperature above 100°C to inhibit the occurrence of cracks and to improve the water resistance.

In a yet further aspect of the present invention there is provided a process for the preparation of cesium-lithium borate crystal having a chemical composition expressed by the formula:

Cs_{2(1-z)}Li₂L_{z}B₁₂O₂₀

(wherein L represents at least one alkali earth metal element and 0 < z < 1), wherein the crystal is annealed at a temperature above 100°C to inhibit the occurrence of cracks and to improve the water resistance.

In such processes the annealing may be carried out at a temperature of from 250 to 350°C for 30 minutes to 5 hours. The annealing may be carried out by keeping the crystal at a temperature of from 100°C to 130°C.

In the accompanying drawings:
Fig. 1 shows a view illustrating the effect of Al doping; and
Fig. 2 shows a microphotograph illustrating a comparison of laser interference transmitted wave surfaces.

The present inventors found the possibility of achieving a high-performance borate crystal so far unknown, in view of the fact that a crystal of a borate such as betabarium metaborate (β-BaB₂O₄), lithium triborate (LiB₃O₅) or cesium triborate (CsB₃O₅), commonly used as a wavelength converting nonlinear optical crystal conventionally for generating ultraviolet rays was a borate crystal in general containing a single metal, by incorporating a plurality of kinds of metal ions.

More specifically, the present inventors prepared several kinds of borate crystals containing two or more kinds of metal ions of an alkali metal, an alkaline earth metal and the like, and carried out an occurrence experiment of double harmonic (wavelength: 532 nm) by irradiating Nd-YAG laser (wavelength: 1,064 nm) onto these borate crystals, thereby searching for the most suitable combination of metals through these many experimental verifications.

As a result, as already proposed, the present inventors found very strong generation of second harmonic from borate crystals including both Cs and Li, and achieved a novel crystal in the form of the cesium-lithium borate crystal and a composition-substituted crystal thereof of the present invention.

The present inventors thus obtained new findings that, when doping a defined element into the new cesium-lithium borate crystal (including a composition-substituted crystal thereof), the occurrence of cracks caused by residual distortion and propagation thereof are effectively inhibited, water solubility is reduced, and water resistance is improved.

Doping of the element can be achieved through mixing of a metal, semi-metal or non-metallic element as described above. For example, one or more selected from the group consisting of Al, Ge, Ti, Hf, Ga, C, Si, Sn, Zn, Cu, Cd, Sb, Bi, V, Ta, Mo, W, Sb, P, Fe, Ni and Co could be doped.

Doping of these elements is made possible through mixing of compounds such as oxides and carbonates during the preparation of crystal.

The present inventors also found the possibility of largely improving optical and mechanical properties of this novel cesium-lithium borate crystal by annealing.

The cesium-lithium borate crystal tends to react to water or moisture in air, and to residual processing distortion on the periphery of crystal. For these reasons, the refractive index of the crystal is changed because the lattice constant of said crystal is transformed. By annealing it, however, the nonuniformity of the refractive index is reduced, leading to the improvement of optical properties. Furthermore, the reduction of residual distortion resulting from annealing inhibits occurrence of cracks.

Annealing can preferably be carried out by way of heating said crystal or keeping said crystal before using it at heating condition, in general at a temperature of at least 100°C. In the case of heating, annealing can be carried out more preferably, at at least 150°C. The preferable temperature range is from 150°C to 450°C, or more preferably, from 250°C to 350°C. On the other hand, in the case of keeping it at heating conditions, the crystal can be kept at a temperature of from 100°C to 130°C. The preferable atmosphere is the open air or an inert gas, in vacuum. There is no particular limitation on the equipment to be used for annealing.

In the present invention, a prescribed crystal is prepared by heating and melting a raw material mixture of initial materials such as cesium carbonate (Cs₂CO₃), lithium carbonate (Li₂CO₃) and boron oxide (B₂O₃).

For a cesium-lithium borate crystal substituted with an alkali metal element or an alkaline earth metal element (M) other than Cs or Li, the suitable composition range in terms of the preparation and physical properties is of the order of 0 < x ≤ 0.01 when the alkali metal element (M) is Na (sodium), 0 < x ≤ 0.1 when M is K (potassium), and 0 < x < 1 when M is Rb (rubidium). A plurality of alkali metal elements may of course be added.

By adding these alkali metal ions, it is possible to change the refractive index of the crystal, thus permitting improvement of the phase alignment angle, the angular allowance and the temperature allowance. By achieving a structural change of crystal, furthermore, it is possible to obtain a more stable crystal harder to be broken or to become white-muddy. As the alkaline earth metal (L), Ba, Sr, Ca and/or Mg ions may be added.

As in the addition of the alkali metal alone, it is possible to change the refractive index of the crystal by adding an alkaline earth metal ion, resulting in improvement of the phase alignment angle, angular allowance and temperature allowance. It is simultaneously possible to obtain a more stable crystal harder to be broken by producing a structural change of the crystal.

In a cesium-lithium borate crystal substituted with an alkali metal ion or an alkaline earth metal ion in the present invention, an element other than the various alkali metals and alkaline earth metals as described above is doped.

The doping ratio in this case, varying with the kinds of elements and the composition of the crystal, may be determined in general with a range of from 0.1 to 10 mol% relative to the entire composition of the crystal as a standard. The doping brings about further improvement of physical, chemical and optical properties of the crystal.

The optical and mechanical properties of the cesium-lithium borate crystal substituted with alkali metal ion or alkaline earth metal ion are largely improved by annealing in the present invention.

The present invention will now be described further in detail by means of the following non-limiting examples.

### Example 1

A cesium-lithium borate crystal (CsLiB₆O₁₀) comprising a stoichiometric composition was prepared by heating and melting a mixture of cesium carbonate (Cs₂CO₃), lithium carbonate (Li₂CO₃) and boron oxide (B₂O₃). The resultant cesium-lithium borate crystal was grown by the seeding method based on the top seeding Cyprus process in a five-layer control growth furnace. The five-layer control growth furnace used for crystal growth had a construction in which a cylindrical platinum crucible was provided in a vertical type five-stage resistance heating furnace capable of keeping a uniform temperature within the furnace. In this cylindrical platinum crucible, seed grains of the cesium-lithium borate crystal of the stoichiometric composition were attached to a platinum wire serving as a nucleus for crystal growth. This seed crystal was rotated at a rate of 15 rotations per minute, and further, crystal growth was conducted while reversing the direction of rotation every three minutes. At this point, the temperature in the platinum crucible was kept at 848°C, the melting point of the crystal. As a result, a transparent and high-quality cesium-lithium borate crystal free from cracks having a size of 2.9 cm x 2.0 cm x 2.2 cm could be grown in about four days. As compared with the conventional growth of a wavelength converting borate nonlinear optical crystal, this is a growth of a very short period of time. According to the growing method of the cesium-lithium borate crystal of the present invention, therefore, it is possible to grow a cesium-lithium borate crystal easily in a very short period of time.

As a result of a crystal structure analysis by means of an X-ray diffraction apparatus, the cesium-lithium borate crystal was found to be a tetragonal crystal falling under space group 142d symmetry group having a crystal lattice constant a = 10.494Å, c = 8.939Å, and a calculated density of 2.461 g/cm³. This cesium-lithium borate crystal has a three-dimensional structure in which a cesium atom is located in the channel of a borate ring composed of boron and oxygen. This is quite a different structure from that of the nonlinear optical crystal LiB₃O₅ or CsB₃O₅ (both are orthorhombic crystals) conventionally used.

This cesium-lithium borate crystal transmitted, from the permeability spectrum, light having a wavelength within the range of from 180 nm to 275 nm, and was transparent. The absorption edge is at 180 nm, which was shorter by about 9 nm as compared with that of the conventional BBO (189 nm).

It was however confirmed that this cesium-lithium borate crystal is hygroscopic when left in the open air for a long period of time. Because processing distortion remains in the crystal periphery and tends to propagate, optical and mechanical properties tend to deteriorate.

With this fact in mind, therefore, Al₂O₃ was mixed in the process of preparation and growth as described above, thereby preparing an Al 12%-doped CLBO crystal to dope Al (aluminum) into the crystal (CLBO crystal) which tends to have deteriorating properties.

An Al:CsLiB₆O₁₀ crystal was grown. This crystal had a structure in which Cs was substituted with Al, with a shorter a-axis and a longer c-axis.

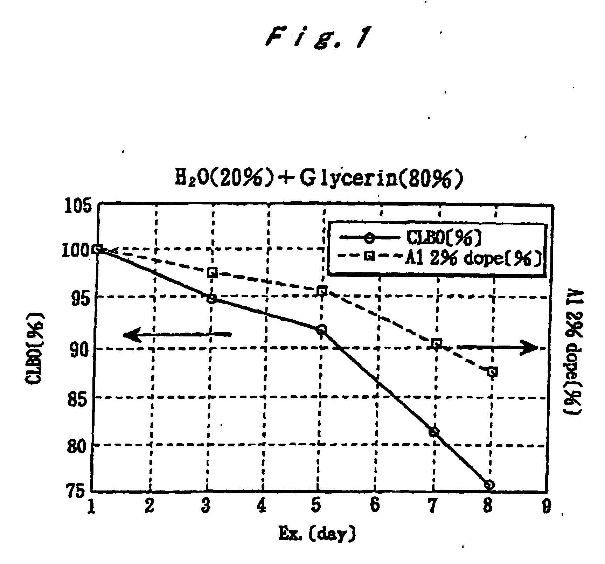

Fig. 1. illustrates the result of study on the water solubility reducing effect on this Al-doped crystal. A water (20%)/glycerine (80%) solution was used as a medium. The result suggests that, as compared with the non-doped CLBO crystal, the water solubility of the 2% Al-doped crystal is remarkably reduced. There is observed a considerable improvement of water resistance. In the optical aspect, the phase alignment wavelength could be reduced.

### Example 2

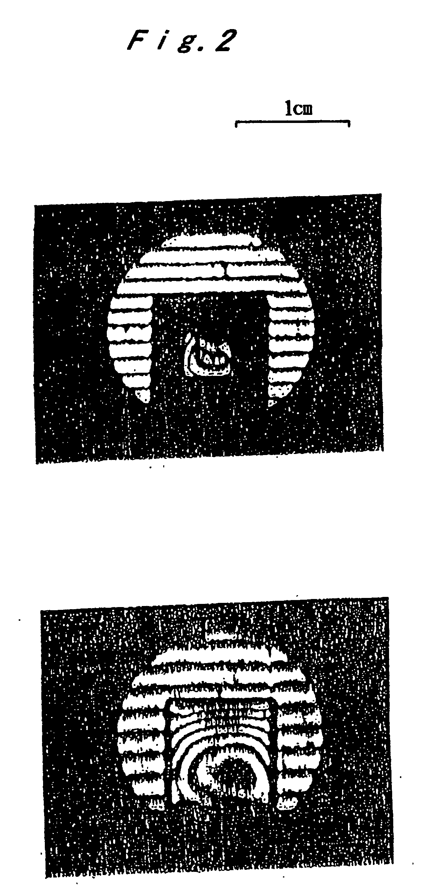

The crystal (CLBO crystal) described in the Example 1, which tends to have deteriorating properties, was annealed in the open air at a temperature of 300°C for three hours. The result revealed that annealing eliminated processing distortion, achieved a uniform refractive index, improved optical properties, and inhibited the occurrence of cracks. Fig. 2 compares a laser interference transmitted wave surface after holding in the open air for three months <A> and a laser interference transmitted wave surface after heat treatment at 300°C for three hours <B>. Fig. 2 also suggests that the effect of annealing is excellent.

### Example 3

The crystal (CLBO) described in the Example 1 was kept at a temperature of 105°C for 6 months in an air atmosphere.

The refractive index and optical properties were improved. This result also suggests that the effect of annealing is excellent.

### Example 4

In the same manner as in Example 1, Al and Ga were doped into CLBO crystals as shown in Table 1 to evaluate Vickers hardness. The result is shown also in Table 1.

The result suggests that, as compared with the CLBO crystal not doped with impurities, mechanical property values are improved, and cracks are prevented.

**Table 1**

| | Vickers hardness (surface a) | Vickers hardness (surface c) |
|---|---|---|
| CLBO | 270 | 180 |
| 1% Al-doped CLBO | 300 | 220 |
| 5% Al-doped CLBO | 310 | 230 |
| 1% Ga-doped CLBO | 270 | 220 |

### Example 5

In the same manner as in Example 1, an Rb (rubidium)-substituted cesium-lithium crystal Cs₁₋ₓLiRbₓ B₆O₁₀ was prepared.

According to the result of evaluation of the resultant crystal by the powder X-ray diffraction method, the sequential increase in the amount of Rb from x = 0.2 to 0.5 and then 0.7 starting from the X-ray diffraction pattern of a sample (Rb, x = 0) not added with Rb leads to a gradual decrease in the angular interval between the reflection of the plane (312) and that of the plane (213). This suggests that Cs and Rb enter the crystal at an arbitrary ratio. The crystal arbitrarily doped with Rb has the same shape of crystal of a tetragonal crystal as that of CLBO not doped with Rb, and a tendency of change in lattice constant is observed.

It is clear from this that, because Rb ion can be added in an arbitrary amount, it is possible to modify the refractive index of the crystal, and to improve the phase alignment angle, angular allowance or temperature allowance.

Similarly with crystals with an amount (x) of added Rb of under 0.1 an improved structural stability of the crystal was confirmed.

For this crystal as well, the effect of Al doping and the effect of 2-hour annealing at a temperature of 320°C were examined, and the same excellent effects as in Examples 1 and 2 were confirmed. This also confirms the improvement of the optical and mechanical properties.

According to the present invention it is possible to improve the optical properties through the achievement of a more uniform refractive index, thus making it possible to obtain a cesium-lithium borate crystal in which the occurrence of cracks is inhibited and the water resistance is improved.

## Claims

1. A cesium-lithium borate crystal having a chemical composition expressed by the formula:
Cs₁₋ₓLi_{1-y}M_{x+y}B₆O₁₀
(wherein M represents at least one alkali metal element other than Cs and Li, and 0 ≤ x+y < 2, 0 ≤ x < 1 and 0 ≤ y < 1), and wherein the crystal contains a doping element, said doping element being a metal other than an alkali metal or an alkaline earth metal, a semi-metal or a non-metallic element and being present in an amount of 0.1 to 10 mol % relative to the crystal composition.

2. A cesium-lithium borate crystal having a chemical composition expressed by the formula:
Cs_{2(1-z)}Li₂L_{z}B₁₂O₂₀
(wherein L represents at least one alkaline earth metal element and 0 < z < 1), and wherein the crystal contains a doping element, said doping element being a metal other than an alkali metal or an alkaline earth metal, a semi-metal or a non-metallic element and being present in an amount of 0.1 to 10 mol % relative to the crystal composition.

3. A process according to claim 1 or claim 2, wherein said element is at least one selected from the group consisting of Al, Ge, Ti, C, Si, Ga, Sn, Cu, Cd, Sb, Bi, V, Ta, Mo, W, Sb and P.

4. A process for the preparation of a crystal as claimed in any preceding claim which includes the step of doping with an element as defined in claim 1 or claim 2.

5. A process according to claim 4 in which the crystal is additionally annealed at a temperature of above 100°C.

6. A process according to claim 5, wherein the annealing is carried out at a temperature of from 250 to 350°C for 30 minutes to five hours.

7. A process according to claim 5, wherein the annealing is carried out by keeping the crystal at a temperature of from 100°C to 130°C.

8. A process for the preparation of cesium-lithium borate crystal having a chemical composition expressed by the formula:
Cs₁₋ₓLi_{1-y}M_{x+y}B₆O₁₀
(wherein M represents at least one alkali metal element other than Cs and Li, and 0 ≤ x+y < 2, 0 ≤ x < 1 and 0 ≤ y < 1), wherein the crystal is annealed at a temperature above 100°C to inhibit the occurrence of cracks and to improve the water resistance.

9. A process for the preparation of cesium-lithium borate crystal having a chemical composition expressed by the formula:
Cs_{2(1-z)}Li₂L_{z}B₁₂O₂₀
(wherein L represents at least one alkaline earth metal element and 0 < z < 1), wherein the crystal is annealed at a temperature above 100°C to inhibit the occurrence of cracks and to improve the water resistance.

10. A process according to claim 8 or claim 9, wherein the annealing is carried out at a temperature of from 250 to 350°C for 30 minutes to five hours.

11. A process according to claim 8 or claim 9, wherein the annealing is carried out by keeping the crystal at a temperature of from 100°C to 130°C.

## Patentansprüche

1. Cäsiumlithiumboratkristall mit einer chemischen Zusammensetzung, die durch die Formel
Cs₁₋ₓLi_{1-y}M_{x+y}B₆O₁₀
ausgedrückt ist, (wobei M mindestens ein Alkalimetallelement darstellt, das nicht Cs und Li ist, und 0 ≤ x+y ≤ 2, 0 ≤ x < 1 und 0 ≤ y < 1 ist), und wobei der Kristall ein Dotierelement enthält, wobei das Dotierelement ein Metall, das kein Alkalimetall oder Erdalkalimetall ist, ein Halbmetall oder ein nichtmetallisches Element ist, und in einer Menge von 0,1 bis 10 Mol-% bezüglich der Kristallzusammensetzung vorliegt.

2. Cäsiumlithiumboratkristall mit einer chemischen Zusammensetzung, die durch die Formel
Cs_{2(1-z)}Li₂L_{z}B₁₂O₂₀
ausgedrückt ist, (wobei L mindestens ein Erdalkalimetallelement darstellt und 0 < 1 < ist), und wobei das Kristall ein Dotierelement enthält, wobei das Dotierelement ein Metall, das kein Alkalimetall oder Erdalkalimetall ist, ein Halbmetall oder ein nichtmetallisches Element ist, und in einer Menge von 0,1 bis 10 Mol-% bezüglich der Kristallzusammensetzung vorliegt.

3. Verfahren nach Anspruch 1 oder Anspruch 2, wobei das Element mindestens eines ist, das aus der aus Al, Ge, Ti, C, Si, Ga, Sn, Cu, Cd, Sb, Bi, V, Ta, Mo, W, Sb und P bestehenden Gruppe ausgewählt ist.

4. Verfahren für die Herstellung eines Kristalls nach einem der vorstehenden Ansprüche, das den Schritt des Dotierens mit einem Element nach der Definition in Anspruch 1 oder Anspruch 2 umfaßt.

5. Verfahren nach Anspruch 4, bei dem das Kristall zusätzlich bei einer Temperatur von über 100 °C getempert wird.

6. Verfahren nach Anspruch 5, wobei das Tempern bei einer Temperatur von 250 bis 350 °C für 30 Minuten bis fünf Stunden durchgeführt wird.

7. Verfahren nach Anspruch 5, wobei das Tempern durch Halten des Kristalls auf einer Temperatur von 100 °C bis 130 °C durchgeführt wird.

8. Verfahren für die Herstellung von Cäsiumlithiumboratkristallen mit einer chemischen Zusammensetzung, die durch die Formel
Cs₁₋ₓLi_{1-y}M_{x+y}B₆O₁₀
ausgedrückt ist (wobei M mindestens ein Alkalimetallelement darstellt, das nicht Cs und Li ist, und 0 ≤ x+y < 2, 0 ≤ x < 1 und 0 ≤ y < 1 ist), wobei der Kristall bei einer Temperatur von über 100 °C getempert wird, um das Auftreten von Rissen zu hemmen und die Wasserbeständigkeit zu verbessern.

9. Verfahren für die Herstellung von Cäsiumlithiumboratkristallen mit einer chemischen Zusammensetzung, die durch die Formel
Cs_{2(1-z)}Li₂L_{z}B₁₂O₂₀
ausgedrückt ist (wobei L mindestens ein Erdalkalimetallelement darstellt und 0 < z < 1 ist), wobei das Kristall bei einer Temperatur von über 100 °C getempert wird, um das Auftreten von Rissen zu hemmen und die Wasserbeständigkeit zu verbessern.

10. Verfahren nach Anspruch 8 oder Anspruch 9, wobei das Tempern bei einer Temperatur von 250 bis 350 °C für 30 Minuten bis fünf Stunden durchgeführt wird.

11. Verfahren nach Anspruch 8 oder Anspruch 9, wobei das Tempern durch Halten des Kristalls auf einer Temperatur von 100 °C bis 130 °C durchgeführt wird.

## Revendications

1. Cristal de borate de césium et de lithium dont la composition chimique est exprimée par la formule :
Cs₁₋ₓLi_{1-y}M_{x+y}B₆O₁₀
(dans laquelle M représente au moins un élément métallique alcalin autre que Cs et Li, et 0 ≤ x+y < 2, 0 ≤ x < 1, et 0 ≤ y < 1), et dans lequel le cristal contient un élément dopant, ledit élément dopant étant un métal autre qu'un métal alcalin ou un métal alcalino-terreux, un élément semi-métallique ou non métallique, et étant présent dans une quantité comprise entre 0,1 et 10 % en moles par rapport à la composition du cristal.

2. Cristal de borate de césium et de lithium dont la composition chimique est exprimée par la formule :
Cs_{2(1-z)}Li₂L_{z}B₁₂O₂₀
(dans laquelle L représente au moins un élément métallique alcalino-terreux et 0 < z < 1), et dans lequel le cristal contient un élément dopant, ledit élément dopant étant un métal autre qu'un métal alcalin ou un métal alcalino-terreux, un élément semi-métallique ou non métallique, et étant présent dans une quantité comprise entre 0,1 et 10 % en moles par rapport à la composition du cristal.

3. Procédé selon la revendication 1 ou la revendication 2, dans lequel ledit élément est au moins un élément choisi dans le groupe constitué d'Al, Ge, Ti, C, Si, Ga, Sn, Cu, Cd, Sb, Bi, V, Ta, Mo, W, Sb, et P.

4. Procédé de préparation d'un cristal tel que revendiqué dans l'une quelconque des revendications précédentes qui contient l'étape de dopage avec un élément tel que défini dans la revendication 1 ou la revendication 2.

5. Procédé selon la revendication 4, dans lequel le cristal est, en outre, recuit à une température supérieure à 100 °C.

6. Procédé selon la revendication 5, dans lequel le recuit est effectué à une température comprise entre 250 et 350 °C pendant 30 minutes à cinq heures.

7. Procédé selon la revendication 5, dans lequel le recuit est effectué en maintenant le cristal à une température comprise entre 100 °C et 130 °C.

8. Procédé de préparation d'un cristal de borate de césium et de lithium ayant une composition chimique exprimée par la formule :
Cs₁₋ₓLi_{1-y}M_{x+y}B₆O₁₀
(dans laquelle M représente au moins un élément métallique alcalin autre que Cs et Li, et 0 ≤ x+y < 2, 0 ≤ x < 1, et 0 ≤ y < 1), dans lequel le cristal est recuit à une température supérieure à 100 °C pour inhiber l'apparition des fissures et pour améliorer la résistance à l'eau.

9. Procédé de préparation d'un cristal de borate de césium et de lithium, dont la composition chimique est exprimée par la formule :
Cs_{2(1-z)}Li₂L_{z}B₁₂O₂₀
(dans laquelle L représente au moins un élément métallique alcalino-terreux et 0 < z < 1), dans lequel le cristal est recuit à une température supérieure à 100 °C pour inhiber l'apparition des fissures et pour améliorer la résistance à l'eau.

10. Procédé selon la revendication 8 ou la revendication 9, dans lequel le recuit est effectué à une température comprise entre 250 et 350 °C, pendant 30 minutes à cinq heures.

11. Procédé selon la revendication 8 ou la revendication 9, dans lequel le recuit est effectué en maintenant le cristal à une température comprise entre 100 °C et 130 °C.
